(19)

Europäisches
Patentamt
European
Patent Office
Office européen
des brevets

(11) **EP 2 234 177 A1**

(12) **EUROPEAN PATENT APPLICATION**
published in accordance with Art. 153(4) EPC

(43) Date of publication:
**29.09.2010 Bulletin 2010/39**

(21) Application number: **08860546.4**

(22) Date of filing: **28.11.2008**

(51) Int Cl.:
**H01L 31/052** (2006.01)

(86) International application number:
**PCT/JP2008/071688**

(87) International publication number:
**WO 2009/075195 (18.06.2009 Gazette 2009/25)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **10.12.2007 JP 2007318717**

(71) Applicant: **Toyota Jidosha Kabushiki Kaisha
Toyota-shi, Aichi 471-8571 (JP)**

(72) Inventor: **SUGA, Yoshinori
Toyota-shi
Aichi 471-8571 (JP)**

(74) Representative: **Winter, Brandl, Fürniss, Hübner,
Röss, Kaiser, Polte - Partnerschaft
Alois-Steinecker-Strasse 22
85354 Freising (DE)**

(54) **SOLAR CELL MODULE**

(57) Disclosed is a solar cell module which can collect solar light to a solar cell, while reducing accumulation of dusts and particles. The solar cell module is provided with a plurality of bifacial solar cells. The solar cells are coated together with a sealing film formed of a sealing resin material. A front surface side transparent board is bonded on the upper surface in the gravity direction, i.e., the front surface of the sealing film. On the front surface side of the front surface side transparent board, a lenticular lens is arranged for collecting solar light to a solar cell by refracting solar light entered from the front surface side of the solar cell module. On the lower surface in the gravity direction, i.e., the rear surface, of the sealing film, a rear surface side transparent board is bonded. On the rear surface side of the rear surface side transparent board, an uneven reflection film is arranged for reflecting solar light entered from the front surface side of the solar cell module and collecting the light to the solar cell.

*Fig.1*

EP 2 234 177 A1

## Description

## Technical Field

The present invention relates to a solar cell module having a solar cell.

## Background Art

As a solar cell module of the related art, a solar cell module including a solar light beam convergence element obtained by sequentially stacking a base film, a lenticular lens, and a low-reflection film on a film-shaped solar cell has been known in the art, for example, as disclosed in Patent Citation 1.

Citation List

[Patent Citation 1] Japanese Unexamined Patent Application Publication No. 10-150213

## Summary of Invention

Technical problem

Since, in the aforementioned solar cell module of the related art, the surface of the solar light beam convergence element has an uneven shape, even in the morning or the evening when solar light is incident in a slanted direction, it is possible to collect solar light to the solar cell. However, dusts or particles may accumulate in the concave portion of the solar light beam convergence element provided in the uppermost layer of the solar cell module. Therefore, photovoltaic performance may be degraded.

The present invention has been made to provide a solar cell module capable of collecting solar light to the solar cell while reducing accumulation of dusts or particles.

Technical Solution

According to the present invention, there is provided a solar cell module including: a solar cell; a cover portion provided on a front surface side and a rear surface side of the solar cell to cover the solar cell; and a lower light-collecting portion provided on the cover portion's rear surface side in an uneven shape to collect solar light to the solar cell, wherein a plurality of the solar cells are provided at intervals to receive light at least at the rear surface, and the lower light-collecting portion has an uneven shape in which a concave shape with respect to the solar cell side is provided in a first location corresponding to the center of the solar cell and a second location corresponding to the interval center between each of the solar cells.

In the solar cell module described above, the solar light incident from the front surface side may be reflected at the lower light-collecting portion, and the solar light incident from the rear surface may be refracted at the lower light-collecting portion and collected to the solar cell. In this case, while the lower light-collecting portion for reflecting or refracting the solar light has an uneven shape, the lower light-collecting portion is provided on the cover portion's rear surface side. Therefore, dusts or particles do not accumulate in the concave portion of the lower light-collecting portion. In addition, the solar light incident from the front surface side may be refracted at the upper light-collecting portion and further reflected at the lower light-collecting portion to collect the solar light to the solar cell by providing the upper light-collecting portion having an uneven shape on the cover portion's front surface side. In this case, since the lower light-collecting portion having an uneven shape exists, it is possible to collect the solar light to the solar cell even when, for example, the unevenness of the upper light-collecting portion is reduced, or the uneven shape of the upper light-collecting portion has a nearly flat shape. Therefore, in comparison with a case that the light-collecting portion having an uneven shape exists only on the cover portion's front surface side, dusts or particles hardly accumulate in the concave portion of the upper light-collecting portion. As a result, it is possible to collect the solar light to the solar cell while reducing accumulation of dusts or particles on the upper face portion of the solar cell module.

In addition, in such a solar cell module, since the solar light incident from the front surface side is reflected at the lower light-collecting portion and collected to the rear surface of the solar cell, it is unnecessary to separately provide a reflection member for reflecting the solar light, and it is possible to guide the solar light from the front surface side to the solar cell using the lower light-collecting portion. Furthermore, since the lower light-collecting portion has an uneven shape in which a concave shape with respect to the solar cell side is provided in the first location corresponding to the center of the solar cell and the second location corresponding to the interval center between each of the solar cells, it is possible to reflect the solar light incident from the front surface side in the lower light-collection portion and effectively collect the solar light to the rear surface of the solar cell.

It is preferable that an apex of the convex portion of the lower light-collecting portion is eccentric from the center between the first location and the second location toward the first location side.

In this case, when the solar light is incident to the solar cell module at a shallow angle, and the solar light is reflected at the apex of the convex portion of the lower light-collecting portion or in the vicinity thereof, the solar light is easily guided to the rear surface of the solar cell. As a result, it is possible to more effectively collect the solar light incident with a large angle range to the solar cell using the lower light-collecting portion.

In addition, preferably, an upper light-collecting portion is further provided on the cover portion's front surface side in an uneven shape to collect the solar light to the solar cell, and the solar cell can receive light at the front surface and the rear surface.

Since the solar cell has a configuration that can receive light at the front surface and the rear surface, a part of the solar light incident from the upper direction is collected to the front surface of the solar cell, and the other part of the solar light is reflected at the lower light-collecting portion and collected to the rear surface of the solar cell. As a result, it is possible to improve the light-collecting efficiency for the solar cell. In addition, since the lower light-collecting portion having an uneven shape is provided on the cover portion's rear surface side, it is possible to make the uneven shape of the upper light-collecting portion to be flat in comparison with the uneven shape of the lower light-collecting portion as described above. Therefore, it is possible to make it difficult for dusts or particles to accumulate in the concave portion of the upper light-collecting portion.

It is preferable that the upper light-collecting portion has an uneven shape in which a concave shape with respect to the solar cell side is provided in a location corresponding to the interval center between each of the solar cells.

In this case, since, for example, the lower light-collecting portion has an uneven shape by cooperatively providing a concave shape with respect to the solar cell side in both a location corresponding to the center of the solar cell and a location corresponding to the interval center between each of the solar cells, it is possible to reflect the solar light incident from the upper direction at the lower light-collecting portion and more effectively collect the solar light to the rear surface of the solar cell.

Furthermore, preferably, the low light-collecting portion has a metal layer formed on a base material to reflect the solar light toward the solar cell side, and the lower light-collecting portion is bonded to other portions by thermally pressing the lower light-collecting portion and other portions under a vacuum contact atmosphere while they are stacked on each other.

In this case, since the encapsulation of the solar cell and the formation of the lower light-collecting portion having a metal layer can be performed in a single process, it is possible to improve productivity and reduce the manufacturing costs of the solar cell module.

Advantageous Effects

According to the present invention, it is possible to collect solar light to the solar cell while reducing the accumulation of dusts or particles. As a result, it is possible to suppress degradation of the photovoltaic performance caused by the accumulation of dusts or particles on the solar cell module.

**Brief Description of Drawings**

Fig. 1 is a cross-sectional diagram illustrating a solar cell module according to an embodiment of the present invention.
Fig. 2 is a top plan view illustrating a solar cell module of Fig. 1.
Figs. 3A and 3B are diagrams illustrating how to evaluate a light reflection property at a regular reflection surface of a reflection film.
Fig. 4 is a cross-sectional diagram illustrating a stack structure of the reflection film of Fig. 1.
Fig. 5 is a conceptual diagram illustrating an aspect that the solar light is collected to the solar cell of Fig. 1.
Fig. 6 is a diagram illustrating a state that the solar cell module of Fig. 1 is preferably mounted on the roof of a house or the like.
Fig. 7 is a conceptual diagram illustrating an aspect where the solar light is collected to the solar cell of Fig. 6.
Fig. 8 is an enlarged diagram illustrating the solar cell module of Fig. 6.
Fig. 9 is a cross-sectional diagram illustrating a modified example of the solar cell module of Fig. 1.
Fig. 10 is a conceptual diagram illustrating an aspect where the solar light is collected to the solar cell of Fig. 9.
Fig. 11 is a cross-sectional diagram illustrating a modified example of the solar cell module of Fig. 1.
Figs. 12A and 12B are schematic diagrams illustrating a solar cell module used in an example.
Fig. 13 is a table illustrating each configuration parameter of the solar cell of Figs. 12A and 12B and a simulation result of the example.

Explanation of Reference Numerals

1...solar cell module,
2...solar cell,
4...encapsulation film (cover portion),
5...front surface side transparent board (cover portion),
7...lenticular lens (upper light-collecting portion),
8...rear surface side transparent board (cover portion),
9...reflection film (lower light-collecting portion),
12...base film (base material),
14...high-reflectance metal layer.

**Description of Embodiments**

Hereinafter, preferable embodiments of the solar cell module according to the present invention will be described in detail with reference to the accompanying drawings.

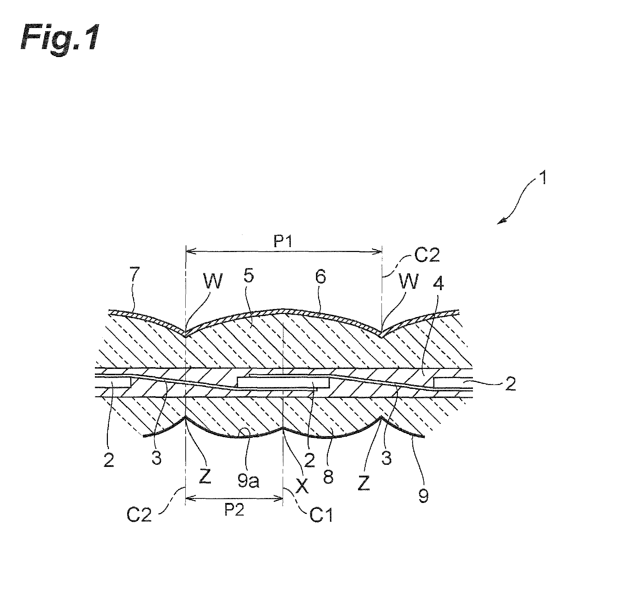

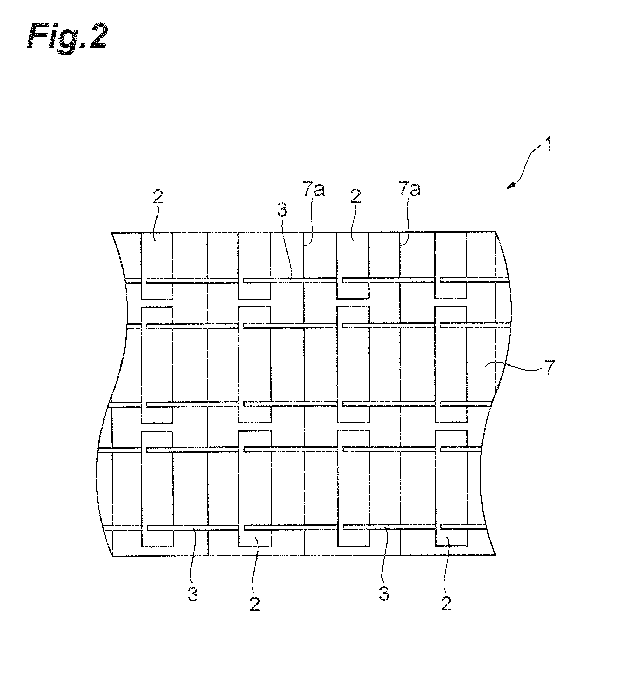

Fig. 1 is a cross-sectional diagram illustrating a solar cell module according to an embodiment of the present invention. Fig. 2 is a top plan view illustrating a solar cell module of Fig. 1. In each drawing, the solar cell module 1 according to the present embodiment is mounted on, for example, a roof of a vehicle or a house, or the like.

The solar cell module 1 includes a plurality of bifacial solar cells 2. The solar cells 2 are arranged in a matrix shape with a predetermined interval. The neighboring solar cells 2 are connected to each other by interposing two interconnectors (lead frame) 3 therebetween. The solar cell 2 is formed of, for example, crystalline silicon which is an inexpensive and abundant resource.

A plurality of the solar cells 2 and a plurality of the interconnectors 3 are collectively covered by the encapsulation film 4 formed of an encapsulation resin material. As the encapsulation resin material, for example, ethylene-vinyl acetate copolymer resin or the like is used. A front surface side transparent board 5 is bonded to the upper face (front surface) in the gravity direction of the encapsulation film 4. The front surface side transparent board 5 is formed of, for example, whiteboard reinforced glass or the like.

The lenticular lens 7 is arranged on the upper face side (the front surface side) in the gravity direction of the front surface side transparent board 5 by interposing a low-refractivity hard coat layer 6 therebetween. The lenticular lens 7 constitutes an upper light-collecting portion for refracting the solar light incident from the front surface side of the solar cell module 1 to collect the solar light to the solar cell 2. The surfaces of the front surface side transparent board 5 and the refractivity hard coat layer 6 have an uneven shape corresponding to the lenticular lens 7.

The rear surface side transparent board 8 is bonded to the lower face (rear surface) in the gravity direction of the encapsulation film 4. The rear surface side transparent board 8 is formed of whiteboard reinforced glass similar to the front surface side transparent board 5. The lower face of the rear surface side transparent board 8 has an uneven shape.

The reflection film 9 having a regular reflection surface (mirror surface) 9a is provided on the lower face side (rear surface side) in the gravity direction of the rear surface side transparent board 8. The reflection film 9 constitutes a lower light-collecting portion for reflecting the solar light incident from the front surface side of the solar cell module 1 to collect the solar light to the solar cell 2.

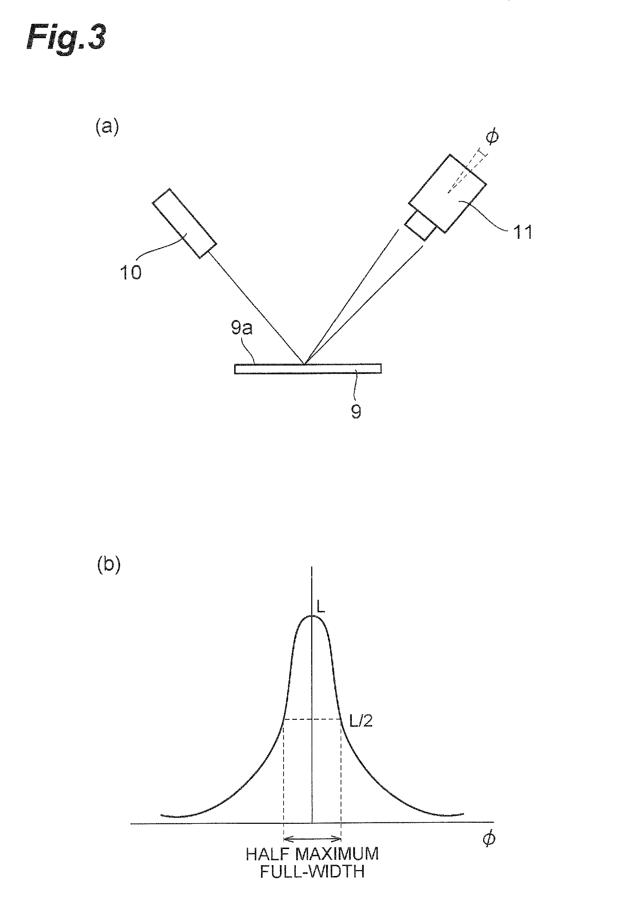

As an optical reflection characteristic of the regular reflection surface 9a of the reflection film 9, for example, as shown in Fig. 3A, the angle distribution at which the peak luminance L becomes 1/2 (half maximum full-width) as shown in Fig. 3B is preferably equal to or smaller than 60°, and more preferably, equal to or smaller than 30° when the laser light from the laser light source 10 is incident to the regular reflection surface 9a at an angle of 45°, and the luminance of the reflection light at that time is measured using a luminance measurement apparatus 11.

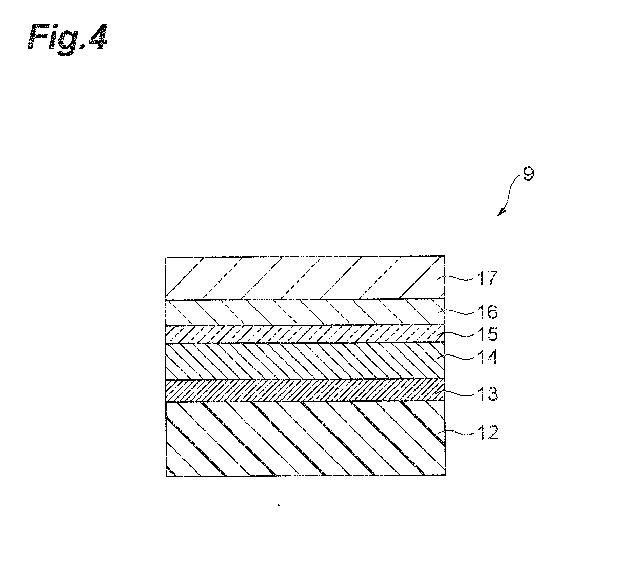

A detailed structure of the reflection film 9 is shown in Fig. 4. In Fig. 4, the reflection film 9 includes a base film 12 made of, for example, thermoplastic resin and a high-reflectance metal layer 14 deposited on the base film 12 to reflect the solar light to the solar cell 2 by interposing the surface functional grouping treatment layer (or anchor coat layer) 13 therebetween. The high-reflectance metal layer 14 constitutes the aforementioned regular reflection surface 9a and is formed of, preferably, metal having a light beam reflectance of 80% or higher at a wavelength of 600 nm such as a silver alloy (a silver-palladium alloy, a silver-gold alloy, a silver-platinum alloy, or the like) or aluminum.

For example, a transparent ceramic deposition layer 15 having a refractivity of, for example, 1.1 to 1.9 is deposited on the high-reflectance metal layer 14, and a transparent ceramic deposition layer 16 having a refractivity of, for example, 2.0 to 3.0 is deposited on the transparent ceramic layer 15. As a ceramic material for forming the low-refractivity transparent ceramic deposition layer 15, silica or the like is used. As a ceramic material for forming the high-refractivity transparent ceramic deposition layer 16, titania or the like is used.

On the transparent ceramic deposition layer 16, a transparent resin coat layer 17 made of transparent resin, for example, having a light beam transmittance of 92% or higher at the wavelength of 600 nm is deposited. The transparent resin coat layer 17 is bonded to the aforementioned rear surface side transparent board 8 (refer to Fig. 1).

In such a reflection film 9, the high-reflectance metal layer 14 constituting the regular reflection surface 9a is rigidly protected by the transparent ceramic deposition layers 15 and 16. In addition, the structure obtained by sequentially stacking the low-refractivity transparent ceramic deposition layer 15 and the high-refractivity transparent ceramic deposition layer 16 on the high-reflectance metal layer 14 increases the light reflectance at the high-reflectance metal layer 14 due to the light reflection action based on the thin film optics. Therefore, even when it is used in an outdoor environment for a long time (such as 20 years), the light reflection characteristics of the reflection film 9 are not degraded.

Returning to Fig. 1, in the solar cell module 1 described above, the reflection film 9 has an uneven shape including a concave shape with respect to the upper side in the gravity direction (the solar cell 2 side, the front surface side) at the location (inflection point X) corresponding to the width direction center of the solar cell 2 and the location (inflection point Z) corresponding to the interval center between the neighboring solar cells 2 along the connection direction of each solar cell 2 and a convex shape with respect to the lower side in the gravity direction at the area between the inflection points X and Z. That is, the inflection points X and Z corresponding to the thin thickness portions of the rear surface side transparent board 8 of the reflection film 9 approximately matches with the width direction center line (hereinafter, referred to as a cell center line) C 1 of the solar cell 2 and the interval center line (hereinafter, referred to as a cell interval center line) C2 between the neighboring solar cells 2, respectively. In this case, the thickness of the inflection point X of the rear surface side transparent board 8 is preferably larger than the thickness of the inflection point Z of the rear surface side transparent board 8.

The lenticular lens 7 has an uneven shape including a concave shape with respect to the lower side in the gravity direction at the location (inflection point W) corresponding to the interval center between the neighboring solar cells 2 along the connection direction of each solar cell 2 and a convex shape with respect to the upper side in the gravity direction in the area between the neighboring inflection points W. That is, the inflection point W corresponding to the thin thickness portion of the front surface side transparent board 5 of the lenticular lens 7 approximately matches with the aforementioned cell interval center line C2.

Therefore, if the unevenness pitch of the lenticular lens 7 is set to P1, and the unevenness pitch of the reflection film 9 is set to P2, the following relationship exists between them.

$$P1 = P2 \times 2$$

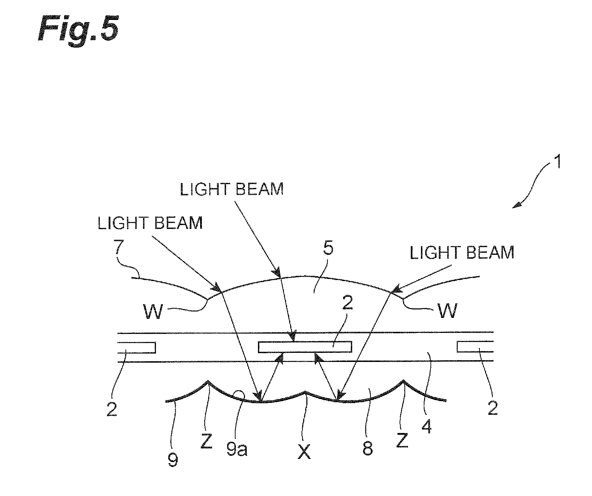

By constructing the lenticular lens 7 and the reflection film 9 as described above, as shown in Fig. 5, the solar light incident to the solar cell module 1 in a slanted direction is converted (refracted) and propagates in the approximately normal direction by the lenticular lens 7. At this moment, a part of the solar light is collected to the upper face of the solar cell 2, and the other part of the solar light is reflected by the reflection film 9 and collected to the lower face of the solar cell 2. For this reason, it is possible to collect the solar light having a wide angle range to the solar cell 2 directly or in a single reflection course.

As a result, even under conditions such as morning or sunset during which the solar light is incident to the solar cell module 1 at a shallow angle, the solar light is collected to the solar cell 2 without repeating a plurality of reflection courses. Therefore, an energy loss caused by collecting the solar light is reduced. In addition, since the wasted solar light that is not collected to the solar cell 2 is reduced, it is possible to suppress the use amount of the solar cell 2.

Since the reflection film 9 has a reflection surface 9a having a regular reflection property, the thermal rays (infrared rays) radiated from the lower face of the solar cell 2 are reflected to the upper direction at the reflection film 9. Therefore, since the thermal rays from the solar cell 2 are effectively guided to the outer side, it is possible to suppress an increase in the temperature of the solar cell 2. Therefore, crystalline silicon which is considered difficult to use due to degradation of photovoltaic efficiency caused by heat can be employed in the solar cell 2. Therefore, it is unnecessary to use expensive semiconductor compounds such as gallium arsenide as the solar cell 2, it is advantageous from the viewpoint of cost or productivity.

In addition, since the solar cell 2 is covered by the encapsulation film 4, and the air layer does not exist in the inner space of the module, the reflection surface 9a of the reflection film 9 is not nearly degraded. For this reason, the integrity for a long-time use is improved, and a mechanical strength against the strong wind is also improved.

When the solar cell module 1 described above is manufactured, each part of the reflection film 9, the rear surface side transparent board 8, the encapsulation film 4, the solar cell 2, the encapsulation film 4, the front surface side transparent board 5, and the lenticular lens 7 are sequentially stacked. It is possible to obtain the solar cell module 1 shown in Fig. 1 by simultaneously thermal-pressing them under the vacuum contact atmosphere, for example, equal to or lower than 30 kPa.

By simultaneously performing the process of encapsulating the solar cell 2 and the process of forming the reflection film 9 in a single process as described above, it is unnecessary to form the reflection film 9 in the subsequent process, for example, using a large-sized sputtering apparatus. In addition, since the process of coating the high-reflectance metal layer 14 and the transparent ceramic deposition layers 15 and 16, or the like for forming the reflection film 9 can be performed by a roll-to-roll process, it is possible to remarkably improve productivity of the deposition process and sufficiently reduce manufacturing costs.

However, when the solar cell 2 is manufactured, for example, as an upper face light receiving type, and the reflection film 9 having the uneven shape is not provided in the lower face in the gravity direction of the solar cell module, the focal length of the lenticular lens 7 needs to be shortened in order to sufficiently collect the solar light incident from the upper direction to the upper face of the solar cell 2. In this case, the unevenness of the lenticular lens 7 increases, and the concave portion of the lenticular lens 7 is deepened. Therefore, dusts or particles may easily accumulate in the concave portion. As a result, the photovoltaic efficiency of the solar cell module becomes degraded.

On the contrary, according to the present embodiment, the reflection film 9 having an uneven shape is provided on the lower face in the gravity direction of the solar cell module 1 using the bifacial solar cell 2, a part of the solar light incident to from the upper direction is directed to the reflection film 9 by the lenticular lens 7, and the solar light is reflected at the reflection film 9 and collected to the lower face of the solar cell 2. Therefore, it is possible to lengthen the focal length of the lenticular lens 7. In addition, it is possible to make the unevenness of the lenticular lens 7 small and sufficiently reduce the depth of the concave portion of the lenticular lens 7. As a result, since dusts or particles may hardly accumulate in the concave portion of the lenticular lens 7, it is possible to reduce cleaning frequency of the solar cell module 1.

In addition, the unevenness pitch P1 of the lenticular lens 7 is set as double the unevenness pitch P2 of the reflection film 9, the inflection points X and Z corresponding to the thin thickness portion of the rear surface side transparent board 8 in the reflection film 9 approximately match with the cell center line C1 and the cell interval center line C2, respectively. The inflection point W corresponding to the thin thickness portion of the front surface side transparent board 5 of the lenticular lens 7 approximately matches with the cell interval center line C2. Therefore, the solar light incident to the module is effectively collected to the solar cell 2.

Furthermore, as described above, since the focal length of the lenticular lens 7 is lengthened, chromatic aberration or astigmatism of the lenticular lens 7 is hardly generated. Therefore, since a larger amount of solar light is collected in the solar cell 2, it is possible to further improve light-collecting efficiency.

As described above, it is possible to effectively collect the solar light to the solar cell 2 while reducing adherence/accumulation of dusts or particles on the upper face of the solar cell module 1. As a result, it is possible to improve photovoltaic efficiency of the solar cell module 1.

In addition, since the unevenness of the lenticular lens 7 is reduced, a de-molding property (molding release property) for forming the front surface side transparent board 5 increases. Therefore, since molding errors are hardly generated, it is possible to improve productivity of the solar cell module 1.

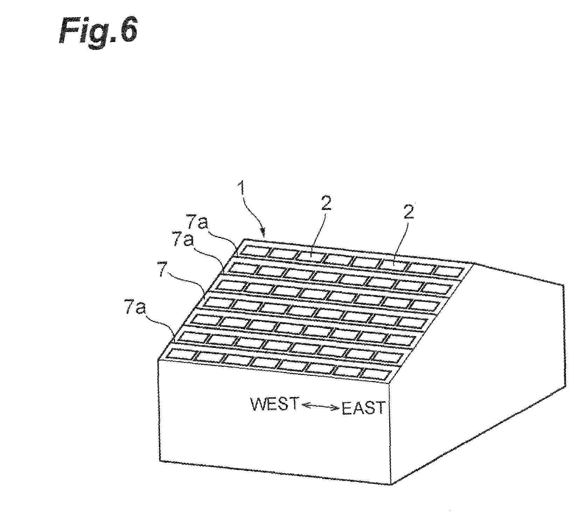

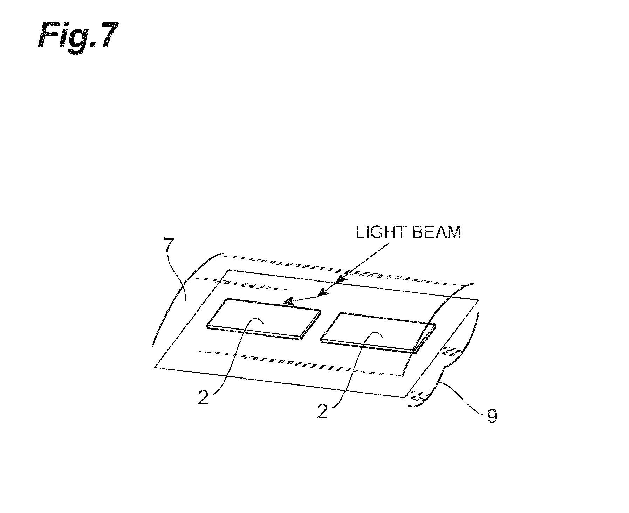

When the aforementioned solar cell module 1 is mounted on the roof of a house, a building, or the like, the solar cell module 1 is preferably arranged such that the ridge line 7a of the lenticular lens 7 follows the east-west direction as shown in Fig. 6. As a result, as shown in Fig. 7, although the solar light significantly changes in the east-west direction, the solar light incident to the solar cell module 1 at a shallow angle during sunrise or sundown is effectively trapped in the solar cell 2. Therefore, it is possible to suppress degradation of light-collecting efficiency over the whole day. In addition, it is possible to collect the solar light to the solar cell 2 while reducing fluctuations caused by the change of seasons as the solar angle changes from the winter to the summer.

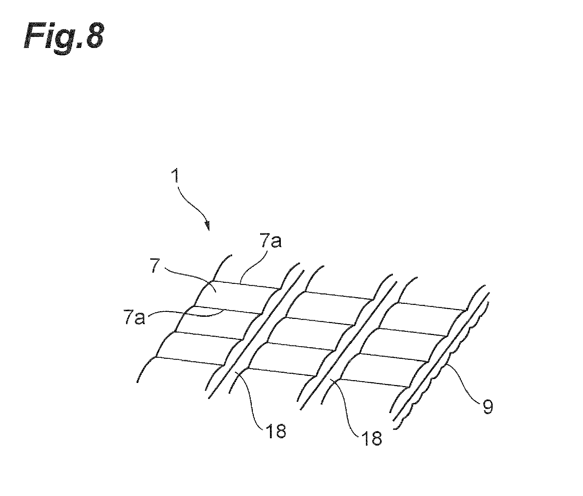

In addition, the solar cell module 1 preferably has a trench portion 18 obtained by notching a part of the lenticular lens 7 and the front surface side transparent board 5 with a predetermined interval as shown in Fig. 8. The trench portion 18 extends in a direction perpendicular to the ridge line direction of the lenticular lens 7. In this case, dusts or particles deposited in the concave portion of the lenticular lens 7 are rapidly cleaned and flows through the trench portion 18 by the rain water. As a result, particularly without performing the cleaning on a regular basis, it is possible to certainly prevent degradation of the photovoltaic efficiency caused by dusts or particles.

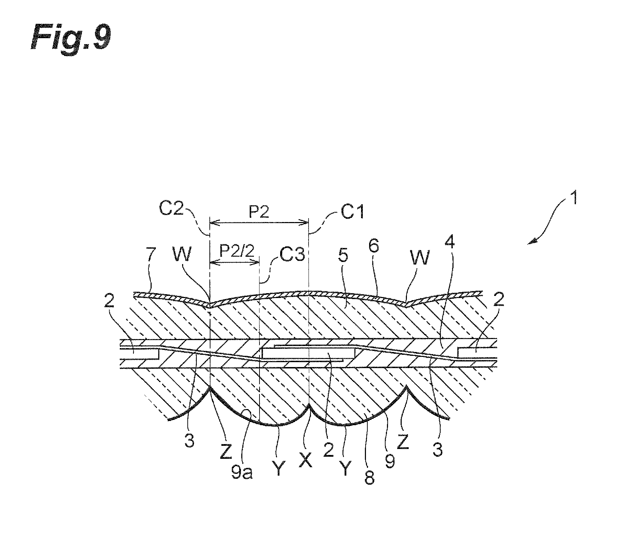

Fig. 9 is a cross-sectional diagram illustrating a modified example of the solar cell module 1 of Fig. 1. In the drawings described below, like reference numerals denote like elements as in the aforementioned embodiments, and descriptions thereof will be omitted.

In Fig. 9, the uneven shape of the lenticular lens 7 and the reflection film 9 of the solar cell module 1 of the present modified example is different from that shown in Fig. 1. Specifically, the apex of the convex portion (inflection point Y) corresponding to the largest thickness portion of the rear surface side transparent board 8 of the reflection film 9 is eccentric to the cell center line C1 side from the convex portion center line C3 (a line passing through the center between the cell center line C1 and the cell interval center line C2) of the reflection film 9.

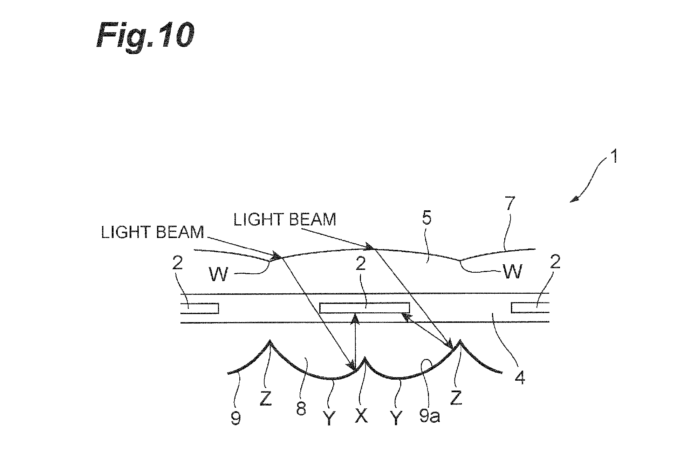

In this construction, the solar light incident to the solar cell module 1 at a shallow angle during the morning or the sunset and reflected near the inflection point Y of the reflection film 9 is reliably directed to the lower face of the solar cell 2 as shown in Fig. 10. Since the focal length of the lenticular lens 7 can increase accordingly, the unevenness of the lenticular lens 7 can be further reduced, and the depth of the concave portion of the lenticular lens 7 can be further reduced. As a result, it is possible to effectively collect the solar light to the solar cell 2 while further reducing adherence/accumulation of dusts or particles on the upper face of the solar cell module 1.

The present invention is not limited to the aforementioned embodiments. For example, while, in the aforementioned embodiments, the inflection points X and Z corresponding to the thin thickness portion of the rear surface side transparent board 8 of the reflection film 9 approximately match with the cell center line C1 and the cell interval center line C2, respectively, and the inflection point W corresponding to the thin thickness portion of the front surface side transparent board 5 of the lenticular lens 7 approximately matches with the cell interval center line C2, the inflection point X may be slightly deviated from the cell center line C1, and the inflection points Z and W may be slightly deviated from the cell center line C2.

In addition, while, in the aforementioned embodiments, the lenticular lens 7 is provided on the upper face in the gravity direction of the solar cell module 1, and the reflection film 9 having the uneven shape is provided on the lower face in the gravity direction of the solar cell module 1, the present invention is not limited to those structures. For example, the solar cell 2 may be a lower face light-receiving type. At the same time, the reflection film 9 or the lenticular lens 7 may be provided on the lower face in the gravity direction of the solar cell module 1, and a light-collecting portion for collecting the solar light to the solar cell 2 may not be provided on the upper face in the gravity direction of the solar cell module.

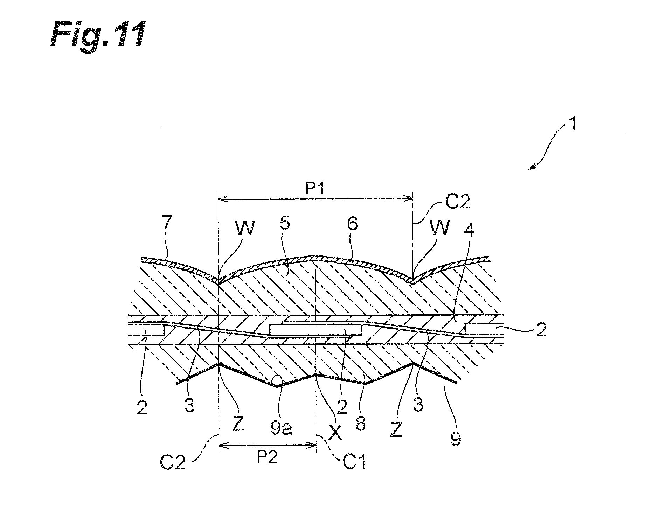

In addition, while, in the aforementioned embodiment, the uneven shapes of the lower face of the rear surface side transparent board 8 and the reflection film 9 are formed in curved faces (refer to Fig. 1), the uneven shape may be formed in a surface shape other than the curved shape. For example, the uneven shape may be formed in a flat surface similar to the rear surface side transparent board 8 and the reflection film 9 shown in Fig. 11.

In addition, while, in the aforementioned embodiments, the solar cell module 1 is mounted on a place having gravity, such as a roof of a vehicle or a house, the present invention may be applied to a place having no gravity.

Hereinafter, examples corresponding to the aforementioned embodiments will be described.

Example 1

A front surface side transparent board including a lenticular lens having an exterior dimension 150 mm×150 mm, a minimum thickness of the thin thickness portion of 3 mm, and an arrangement pitch (unevenness pitch) P1 of the lenticular lens of 30 mm was injection-molded of mold injection type grade polycarbonate resin (Lexan manufactured by Asahi Glass Co., Ltd.) using an injection/compression molding machine (Toshiba Machine Co., Ltd). The focal length f of the lenticular lens was set to 50 mm. On the surface of the lenticular lens, a fluorine-based coating film (Cytop manufactured by Asahi Glass Co., Ltd.) was coated by a dipping method to increase its antifouling property and antireflection property.

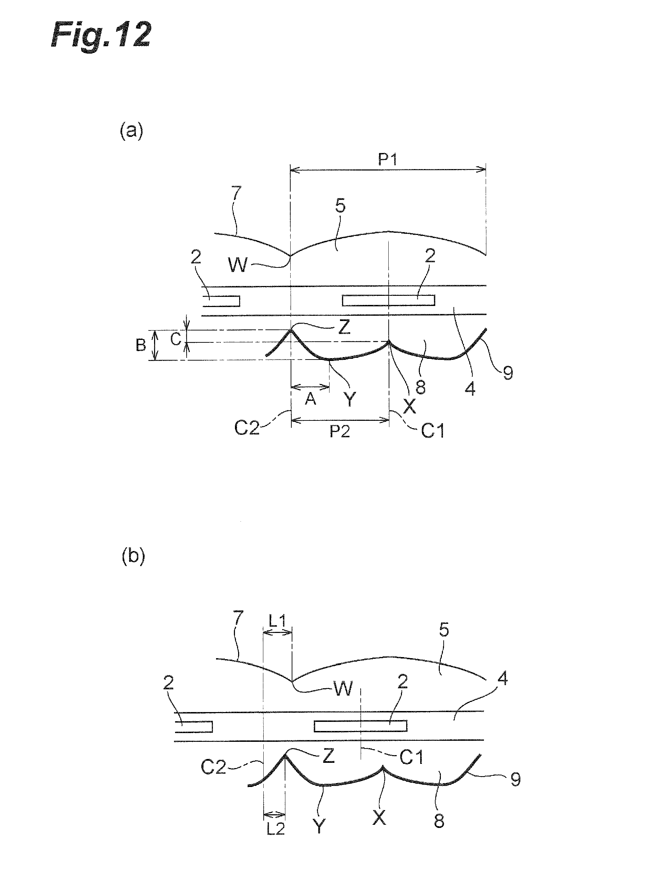

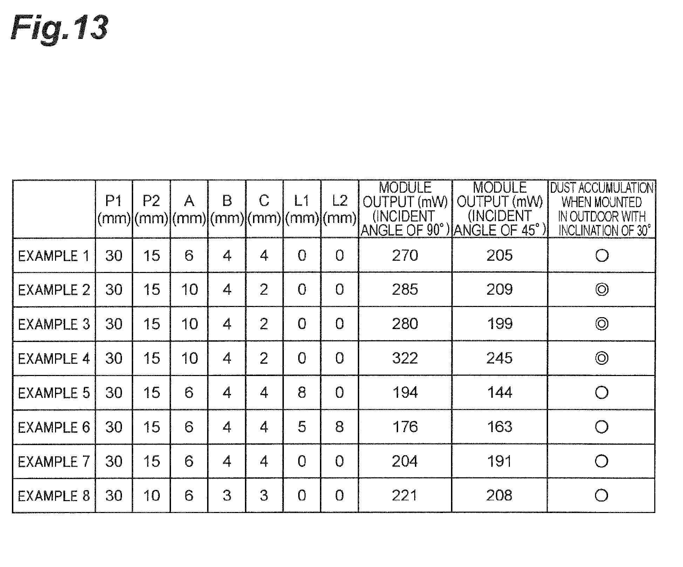

Similarly, a rear surface side transparent board having an exterior dimension of 150 mm×150 mm, a minimum thickness of the thin thickness portion of 7 mm, and an arrangement pitch (unevenness pitch) P2 of the convex surface array portion of 15 mm was molded by a mold injection of polycarbonate resin. In the cross-section of the convex surface array portion functioning as a regular reflection surface, each configuration parameter shown in Figs. 12A and 12B was set to the value shown in Fig. 13.

Next, a surface functional grouping treatment (anti-adhesion treatment) was performed for the convex surface array portion using a corona discharge machining, and silver-palladium alloy (a concentration of palladium is 5 wt%) having a thickness of 200 nm was deposited using a sputtering method to provide a regular reflection surface (mirror surface). In addition, a silver-palladium alloy protection film was provided by flow-coating acrylate photo-polymerized resin having a film thickness of 5 $\mu$m on the silver-palladium alloy sputtering film and irradiating ultraviolet rays thereon. In this case, the regular reflection property on the sputtering film of the flat polycarbonate substrate under the same condition was set to a half maximum full-width of 7°.

Next, a single crystalline bifacial solar cell (having a size of 10 mm×125 mm and a thickness of 200 $\mu$m) which has an n+/p/p+ bonding structure by performing an anti-reflection process and a texture process was prepared. Then, as shown in Figs. 1 and 2, the pitch between solar cells was set to 30 mm similar to the unevenness pitch P1 of the lenticular lens, and cell strings connected in series were manufactured by a reflow soldering using a lead frame having a width of 2 mm.

Subsequently, locations of the cell strings including the bifacial solar cells were determined with high accuracy in such a way that, as shown in Fig. 1, the cell center line C1 is laid on the focal point axis of the lenticular lens, the inflection point Z of the thin thickness portion of the rear surface side transparent board matches with the cell interval center line C2, and the inflection point W of the thin thickness portion of the lenticular lens matches with the cell interval center line C2.

Subsequently, a back sheet (manufactured by NK packaging Inc.) for the solar cell module having a laminate structure made of A-PET/aluminum film/A-PET was provided in the lower portion of the rear surface side transparent board (in the side where the regular reflection surface is formed) by inserting the cell string between two encapsulation films (EVA films manufactured by Mitsui Chemical Fabro, Inc.) having a thickness of 600 $\mu$m and made of ethylene-vinyl acetate copolymer resin and then inserting them between front surface side transparent board and the rear surface side transparent board. In addition, the solar cell module was manufactured by performing a vacuum dry laminate under a thermal-press condition for 15 minutes at a temperature of 135 °C using a diaphragm-type vacuum dry laminator (manufactured by NPC Inc.).

In addition, the module output electric power was simulated when the light is incident to the solar cell module at an angle of 90° and 45°. In addition, the state of dust accumulated in the lenticular lens was simulated by assuming that the solar cell module is provided to be slanted at an angle of 30° with respect to the horizontal plane.

The results of the simulation are shown in Fig. 13. Since the cell center line C1 maches with the focal point axis of the lenticular lens, and the inflection point Z of the rear surface side transparent board and the inflection point W of the lenticular lens match with the cell interval center line C2, a desired module output electric power was achieved by effectively collecting the light to the solar cell. In addition, since the lenticular lens having a relatively small unevenness size is used, the amount of dust accumulated in the surface of the lenticular lens was reduced.

Example 2

The front surface side transparent board including the lenticular lens having the exterior dimension and the unevenness pitch similar to those of the Example 1 was injection-molded. The focal length f of the lenticular lens was set to 120 mm. Since a fluorine-based coat film (Cytop manufactured by Asahi Glass Co., Ltd.) was coated on the surface of the lenticular lens using a dipping method, it is possible to improve the antifouling property and the anti-reflection property.

The rear surface side transparent board was obtained by injection-molding a transparent board having the same exterior dimension as that of Example 1, and the unevenness pitch P2 was set to the same value as that of Example 1. In addition, the cross-sectional shape of the rear surface side transparent board was formed such that the inflection point Y of the thick thickness portion is biased to the cell center lines C1 side as shown in Fig. 9. In addition, the regular reflection property of the silver alloy sputtering film provided in the rear surface side transparent board was set to a half maximum full-width of 7° similar to Example 1.

Similar to Example 1, locations of the cell strings were determined with high accuracy in such a way that the inflection point Z of the thin thickness portion of the rear surface side transparent board matches with the cell interval center line C2, and the inflection point W of the thin thickness portion of the lenticular lens matches with the cell interval center line C2.

The simulation similar to that of Example 1 was performed. As a result, the module output electric power further increases by collecting light with sufficiently high efficiency due to the effect of eccentricity in the inflection point Y of the rear surface side transparent board. In addition, since the lenticular lens having a sufficiently long focal length is used, accumulation of dust on the surface of the lenticular lens was further suppressed.

Example 3

On the front surface side transparent board of Example 2, a trench portion having a width of 2 mm was provided with a pitch of 30 mm along the ridge line of the lenticular lens as shown in Fig. 8. Other configurations were similar to those of Example 2.

Then, the simulation was performed as described above. As a result, since dust is easily cleaned by rain water and flows by providing the trench portion, accumulation of dust on the surface of the lenticular lens was significantly reduced.

Example 4

Instead of the silver alloy sputtering film formed on the rear surface side transparent board in Example 1, a reflection film having a regular reflection layer was formed as shown in Fig. 4. As a base material of the reflection film, an A-PET film having a thickness of 175 $\mu$m formed by a T-die extrusion molding was used. A corona discharge treatment was applied to this film, and a surface functional grouping treatment was performed. Further, acrylic photo-polymerization monomer was coated on one surface thereof with a thickness of 10 $\mu$m using a roll coater, and the photo-polymerization monomer was cured by irradiating ultraviolet rays.

Then, the film was sufficiently thermally dried, and a discharge gas was removed. Then, the film was introduced into a roll-to-roll type vacuum deposition apparatus, and a silver alloy deposition layer was formed by depositing a silver/palladium alloy including silver 97% and palladium 3% with a film thickness of 550 nm on the surface where the photo-polymerization monomer was coated. Then, an optical thin film including titanium oxide was formed by sputtering silica with a thickness of 300 nm under an oxygen atmosphere using a roll-to-roll type magnetron sputtering apparatus and sputtering titanium with a thickness of 200 nm under an oxygen atmosphere.

Subsequently, an acrylic photo-polymerization monomer was coated with a thickness of 10 $\mu$m on the titanium oxide deposition surface using a roll coater, and the photo-polymerization monomer was cured by irradiating ultraviolet rays. Finally, the reflection film was obtained by welding a syndiotactic polypropylene-based heat sealant with a thickness of 20 $\mu$m using a thermal roll.

The rear surface side transparent board, the EVA film, the cell string, the EVA film, and the front surface side transparent board were arranged in this order on the reflection film obtained as described above. Then, the solar cell module was manufactured by performing a vacuum dry laminate under a thermal press condition described above using a diaphragm-type vacuum dry laminator (manufactured by NPC Inc.).

Then, the simulation was performed as described above. Since a regular reflection surface having a high reflectance can be effectively formed through a roll-to-roll process, it was possible to improve electric-generating properties, obtain stable quality, and improve productivity.

Examples 5 and 6

A solar cell module was manufactured by changing the location shift amount L1 of the inflection point W of the thin thickness portion of the lenticular lens against the cell interval center line C2 and the location shift amount L2 of the inflection point Z of the thin thickness portion of the rear surface side transparent board against the cell interval center line C2 (refer to Fig. 12B) using the front surface side transparent board and the rear surface side transparent board having the same exterior dimensions as those of Example 1.

Then, the simulation was performed as described above. As a result, while the module output electric power was reduced in either case in comparison with Example 1, it was possible to obtain a minimum level. In addition, the accumulation state of dust on the lenticular lens was similar to that of Example 1 in either case.

Example 7

A solar cell module was manufactured by biasing the location of the inflection point Y of the thick thickness portion of the rear surface side transparent board toward a direction distant from the cell center line C1 using the front surface side transparent board and the rear surface side transparent board having the same exterior dimensions as those of Example 2.

Then, the simulation was performed as described above. As a result, while the module output electric power was reduced in comparison with Example 1, it was possible to obtain a minimum level. In addition, the accumulation state of dust on the lenticular lens was similar to that of Example 1.

Example 8

A solar cell module was manufactured by setting the relationship between the unevenness pitch P1 of the lenticular lens and the unevenness pitch P2 of the rear surface side transparent board to $P1 \neq 2 \times P2$ using the front surface side transparent board and the rear surface side transparent board having the same exterior dimensions as those of Example 2.

Then, the simulation was performed as described above. As a result, while the module output electric power was reduced in comparison with Example 1, it was possible to obtain a minimum level. In addition, the accumulation state of dust on the lenticular lens was similar to that of Example 1.

**Industrial Applicability**

According to the present invention, it is possible to collect the solar light to the solar cell while reducing accumulation of dusts or particles. As a result, it is possible to suppress degradation of photovoltaic performance caused by accumulation of dusts or particles on the solar cell module.

**Claims**

1. A solar cell module comprising:

   a solar cell;
   a cover portion provided on a front surface side and a rear surface side of the solar cell to cover the solar cell; and
   a lower light-collecting portion provided on the cover portion's rear surface side in an uneven shape to collect solar light to the solar cell,
   wherein a plurality of the solar cells are provided at an interval to receive light at least at the rear surface, and
the lower light-collecting portion has an uneven shape in which a concave shape with respect to the solar cell side is provided in a first location corresponding to a center of the solar cell and a second location corresponding to an interval center between each of the solar cells.

2. The solar cell module according to claim 1, wherein an apex of the convex portion of the lower light-collecting portion is eccentric from the center between the first location and the second location toward the first location side.

3. The solar cell module according to claim 1, further comprising an upper light-collecting portion provided on the cover portion's front surface side in an uneven shape to collect the solar light to the solar cell, wherein the solar cell can receive light at the front surface and the rear surface.

4. The solar cell module according to claim 3, wherein the upper light-collecting portion has an uneven shape in which a concave shape with respect to the solar cell side is provided in a location corresponding to an interval center between each of the solar cells.

5. The solar cell module according to any one of claims 1 to 4, wherein the low light-collecting portion has a metal layer formed on a base material to reflect the solar light toward the solar cell side, and
the lower light-collecting portion is bonded to other portions by thermally pressing the lower light-collecting portion and other portions under a vacuum contact atmosphere while they are stacked on each other.

# Fig.1

# Fig.2

# *Fig.3*

(a)

(b)

HALF MAXIMUM
FULL-WIDTH

*Fig.4*

# *Fig.5*

## Fig.6

**Fig.7**

LIGHT BEAM

# Fig.8

# Fig.9

# Fig.10

*Fig.11*

# *Fig.12*

(a)

(b)

EP 2 234 177 A1

Fig.13

| | P1 (mm) | P2 (mm) | A (mm) | B (mm) | C (mm) | L1 (mm) | L2 (mm) | MODULE OUTPUT (mW) (INCIDENT ANGLE OF 90°) | MODULE OUTPUT (mW) (INCIDENT ANGLE OF 45°) | DUST ACCUMULATION WHEN MOUNTED IN OUTDOOR WITH INCLINATION OF 30° |
|---|---|---|---|---|---|---|---|---|---|---|
| EXAMPLE 1 | 30 | 15 | 6 | 4 | 4 | 0 | 0 | 270 | 205 | ○ |
| EXAMPLE 2 | 30 | 15 | 10 | 4 | 2 | 0 | 0 | 285 | 209 | ◎ |
| EXAMPLE 3 | 30 | 15 | 10 | 4 | 2 | 0 | 0 | 280 | 199 | ◎ |
| EXAMPLE 4 | 30 | 15 | 10 | 4 | 2 | 0 | 0 | 322 | 245 | ◎ |
| EXAMPLE 5 | 30 | 15 | 6 | 4 | 4 | 8 | 0 | 194 | 144 | ○ |
| EXAMPLE 6 | 30 | 15 | 6 | 4 | 4 | 5 | 8 | 176 | 163 | ○ |
| EXAMPLE 7 | 30 | 15 | 6 | 4 | 4 | 0 | 0 | 204 | 191 | ○ |
| EXAMPLE 8 | 30 | 10 | 6 | 3 | 3 | 0 | 0 | 221 | 208 | ○ |

## INTERNATIONAL SEARCH REPORT

| International application No. |
| --- |
| PCT/JP2008/071688 |

A.  CLASSIFICATION OF SUBJECT MATTER
*H01L31/052*(2006.01)i

According to International Patent Classification (IPC) or to both national classification and IPC

B.  FIELDS SEARCHED

Minimum documentation searched (classification system followed by classification symbols)
H01L31/00-31/20

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho   1971-2009   Toroku Jitsuyo Shinan Koho    1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 11-307791 A  (Sanyo Electric Co., Ltd.),<br>05 November, 1999 (05.11.99),<br>(Family: none) | 1,3,5<br>2,4 |
| X<br>Y | WO 89/05520 A1  (Fraunhofer),<br>15 June, 1989 (15.06.89),<br>& DE 3741485 A          & EP 347443 A | 1<br>2-5 |
| Y | JP 11-243225 A  (Hitachi, Ltd.),<br>07 September, 1999 (07.09.99),<br>& CN 1227419 A          & DE 19907506 A<br>& US 2001/0008144 A1 | 1-5 |

| [X]   Further documents are listed in the continuation of Box C. | [ ]   See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>  23 January, 2009 (23.01.09) | Date of mailing of the international search report<br>  03 February, 2009 (03.02.09) |
| --- | --- |
| Name and mailing address of the ISA/<br>  Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/071688

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 98/31054 A1  (Hitachi, Ltd.),<br>16 July, 1998 (16.07.98),<br>(Family: none) | 1-5 |
| Y | WO 2005/074039 A1  (Kyocera Corp.),<br>11 August, 2005 (11.08.05),<br>& US 2008/0283115 | 1-5 |
| Y | JP 2006-344964 A  (General Electric Co.),<br>21 December, 2006 (21.12.06),<br>& US 2006/0272698 A1    & EP 1732141 A1<br>& CN 1877865 A | 1-5 |
| Y | JP 60-128678 A  (Fuji Electric Co., Ltd.),<br>09 July, 1985 (09.07.85),<br>(Family: none) | 1-5 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10150213 A